# FASCICULE DE BREVET EUROPEEN

(11) **EP 3 631 885 B1**
(45) Date de publication et mention de la délivrance du brevet: **04.11.2026**
(21) Numéro de dépôt: 18730667.5
(22) Date de dépôt: 31.05.2018
(51) Int. Cl.: H01M 8/04992, G01R 31/396, G01R 31/3835, H01M 8/04537

(54) **PROCÉDÉ ET SYSTÈME POUR DIAGNOSTIQUER EN TEMPS RÉEL L'ETAT DE FONCTIONNEMENT D'UN SYSTÈME ÉLECTROCHIMIQUE, ET SYSTÈME ÉLECTROCHIMIQUE INTÉGRANT CE SYSTÈME DE DIAGNOSTIC**
VERFAHREN UND SYSTEM ZUR DIAGNOSE DES BETRIEBSZUSTANDES EINES ELEKTROCHEMISCHEN SYSTEMS IN ECHTZEIT UND ELEKTROCHEMISCHES SYSTEM MIT DIESEM DIAGNOSESYSTEM
METHOD AND SYSTEM FOR DIAGNOSING THE OPERATING STATE OF AN ELECTROCHEMICAL SYSTEM IN REAL-TIME, AND ELECTROCHEMICAL SYSTEM INCORPORATING THIS DIAGNOSTIC SYSTEM

(30) Priorité: 02.06.2017 FR 1754949
(43) Date de publication de la demande: 08.04.2020
(73) Titulaire: Université de Franche-Comté, 25000 Besançon (FR); Université Gustave Eiffel, 77420 Champs-sur-Marne (FR)
(72) Inventeur: FAIVRE, Sébastien, 90000 Belfort (FR); GUSTIN, Frédéric, 90300 Valdoie (FR); HISSEL, Daniel, 70250 Ronchamp (FR); HAREL, Fabien, 90200 Giromagny (FR); LI, Zhongliang, 13013 Marseille (FR)
(74) Mandataire: INNOV-GROUP
(86) Numéro de dépôt international: PCT/EP2018/064346
(87) Numéro de publication internationale: WO 2018/220115

(56) Documents cités:
- EP-A2- 2 778 700
- WO-A1-2015/101570
- WO-A2-02/27342
- GB-A- 2 527 584
- NADIA YOUSFI STEINER ET AL: "Non intrusive diagnosis of polymer electrolyte fuel cells by wavelet packet transform", INTERNATIONAL JOURNAL OF HYDROGEN ENERGY, ELSEVIER SCIENCE PUBLISHERS B.V., BARKING, GB, vol. 36, no. 1, 11 October 2010 (2010-10-11), pages 740 - 746, XP028131002, ISSN: 0360-3199, [retrieved on 20101019], DOI: 10.1016/J.IJHYDENE.2010.10.033

## Description

### Domaine technique

La présente invention concerne un procédé pour diagnostiquer en temps réel l'état de fonctionnement d'un système électrochimique. Elle vise également un système de diagnostic mettant en œuvre ce procédé, ainsi qu'un système électrochimique, notamment une pile à combustible, intégrant ce système de diagnostic.

### Etat de la technique antérieure

Les piles à combustible actuelles, qu'elles soient embarquées ou stationnaires, doivent faire l'objet d'une surveillance de leur état, afin notamment de prévenir une défaillance ou une dégradation de leur fonctionnement.

Il existe déjà des procédés de détection de défauts dans une pile à combustible, qui ne peuvent être mis en œuvre que hors fonctionnement de cette pile et dans un contexte de laboratoire. Ces méthodes mettent parfois en œuvre des capteurs intrusifs.

Par ailleurs, pour des piles à combustible à forte valeur ajoutée, utilisées par exemple en milieu nécessitant un fonctionnement certain à tout moment, tel qu'en milieu hospitalier par exemple, des méthodes de détection impliquant une mise hors fonctionnement temporaire ne sont pas envisageables.

Le document EP 2778700 A2 divulgue un équipement pour prédire l'état d'un pack batterie, utilisant des transformations d'ondelette discrètes.

Le document "Non intrusive diagnosis of polymer electrolyte fuel cells by wavelet packet transform » de Nadia Yousfi Steiner et al., paru dans International Journal of Hydrogen Energy, Elsevier Science Publishers B.V., Barking,GB, vol.36, No1, 11 octobre 2010, pages 740-746*,* divulgue un procédé de diagnostic de cellules de piles à combustibles polymères, mettant en oeuvre des mesures de tension de piles, et une transformation en paquet d'ondelette.

Le but de la présente invention est de proposer un nouveau procédé de détection de défauts dans un système électrochimique, notamment une pile à combustible, qui permette de connaître l'état de ce système en fonctionnement et sans capteur intrusif et/ou complexe ou coûteux, avec des performances supérieures, en termes de qualité et de fiabilité des détections des défauts, à celles habituellement observées sur les procédés actuels de diagnostic.

### Exposé de l'invention

Cet objectif est atteint avec un procédé, selon la revendication 1, pour diagnostiquer en temps réel l'état de fonctionnement d'un système électrochimique comprenant un empilement de cellules, ce procédé comprenant des étapes pour réaliser des mesures de tension desdites cellules, caractérisé en ce qu'il comprend en outre :
- un traitement des mesures de tension ainsi réalisées en temps réel pour en extraire des formes d'onde spécifiques,
- une transformation desdites formes d'onde spécifiques pour en générer des points spécifiques du fonctionnement temps-réel dudit système électrochimique, et
- une comparaison desdits points spécifiques du fonctionnement temps-réel et de points spécifiques d'un fonctionnement hors-ligne dudit système électrochimique qui sont issus d'une transformation de formes d'onde spécifiques extraites de mesures de tension effectuées hors ligne alors que ledit système électrochimique est placé dans des états de fonctionnement connus incluant des états de défaut, de façon à produire des informations sur l'état de fonctionnement temps-réel dudit système électrochimique.

Les étapes de mesure de tension de cellule peuvent être effectuées périodiquement.

Les formes d'onde spécifiques extraites des mesures de tension effectuées hors-ligne et/ou en temps réel sont soumises à une transformation mathématique - appelée « Shapelet Transform » - pour créer des points spécifiques à partir de formes d'onde spécifiques.

Ces points spécifiques peuvent être identifiés dans un espace bidimensionnel (2D) puis classés dans un espace tridimensionnel (3D).

Dans un premier mode particulier de réalisation du procédé selon l'invention, des points spécifiques sont classés au moyen d'une fonction de type SSM-SVM (pour « Sphere Shaped Multi-Class - Support Vector Machine »).

Dans un second mode particulier de réalisation du procédé selon l'invention, des points spécifiques sont classés au moyen d'une fonction de type kNN (pour « K Nearest Neighbor »).

Dans un troisième mode particulier de réalisation du procédé selon l'invention, des points spécifiques sont classés au moyen d'une fonction de type GMM (pour « Gaussian Mixture Model »).

Le procédé de diagnostic selon l'invention peut en outre avantageusement comprendre une constitution initiale d'une base de données par apprentissage sur des états de fonctionnement connus du système électrochimique, qui sont testés hors ligne.

Lorsque le procédé selon l'invention est mis en œuvre pour diagnostiquer l'état de fonctionnement d'une pile à combustible, les états de fonctionnement connus qui sont testés hors ligne comprennent tout ou partie des états suivants : Fonctionnement normal, Pression basse hydrogène, Stœchiométrie basse du côté air, Asséchement, Noyage.

Suivant un autre aspect de l'invention, il est proposé un système selon la revendication 9, pour diagnostiquer l'état de fonctionnement en temps réel d'un système électrochimique comprenant un empilement de cellules, mettant en œuvre le procédé de diagnostic selon l'invention, ce système de diagnostic comprenant des moyens pour mesurer les tensions aux bornes desdites cellules, caractérisé en ce qu'il comprend en outre :
- des moyens pour traiter les tensions ainsi mesurées pour en extraire des formes d'onde spécifiques, des moyens pour transformer selon une transformation appelée « Shapelet transform », lesdites fonctions d'onde spécifiques pour en générer des points spécifiques du fonctionnement temps-réel dudit système électrochimique, et
- des moyens pour comparer lesdits points spécifiques du fonctionnement temps-réel et des points spécifiques d'un fonctionnement hors-ligne dudit système électrochimique qui sont issus d'une transformation de formes d'onde spécifiques extraites de mesures de tension effectuées hors ligne - alors que ledit système électrochimique est placé dans des états de fonctionnement connus incluant des états de défaut, de façon à produire des informations de diagnostic de l'état de fonctionnement temps-réel dudit système électrochimique.

Le système de diagnostic selon l'invention peut en outre avantageusement comprendre des moyens pour transformer les formes d'onde spécifiques extraites des mesures de tension effectuées hors-ligne et/ou en temps réel, de façon à créer des points spécifiques.

Ce système de diagnostic peut en outre comprendre des moyens pour identifier les points spécifiques dans un espace bidimensionnel (2D) et des moyens pour classer lesdits points spécifiques ainsi identifiés dans un espace tridimensionnel (3D), ainsi qu'une base de données par apprentissage sur des états de fonctionnement connus du système électrochimique.

Suivant encore un autre aspect de l'invention, il est proposé un système électrochimique intégrant un système de diagnostic selon l'invention. Ce système électrochimique peut notamment comporter une pile à combustible.

### Description des figures

D'autres avantages et particularités de l'invention apparaîtront à la lecture de la description détaillée de mises en œuvre et de modes de réalisation nullement limitatifs, et des dessins annexés suivants :
- la figure 1 illustre schématiquement le principe de mesure de tension mis en œuvre dans le procédé de détection de défauts selon l'invention ;
- la figure 2 illustre schématiquement une mise en œuvre d'un microcontrôleur pour des mesures analogiques ;
- la figure 3 représente un dispositif de mesure de tension mis en œuvre dans un exemple de réalisation d'un système de détection de défauts selon l'invention ;
- la figure 4 représente des formes d'onde spécifiques (ou « shapelets ») produits dans le procédé de détection de diagnostic selon l'invention ;
- la figure 5 illustre une classification des formes d'onde spécifiques avec la méthode SSM-SVM ; et
- la figure 6 illustre schématiquement un exemple de réalisation du procédé de diagnostic selon l'invention.

### Modes de réalisation détaillés

Ces modes de réalisation étant nullement limitatifs, on pourra notamment considérer des variantes de l'invention ne comprenant qu'une sélection de caractéristiques décrites ou illustrées par la suite isolées des autres caractéristiques décrites ou illustrées (même si cette sélection est isolée au sein d'une phase comprenant ces autres caractéristiques), si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, et/ou avec seulement une partie des détails structurels si cette partie uniquement est suffisante pour conférer un avantage technique ou à différencier l'invention par rapport à l'état de la technique antérieure.

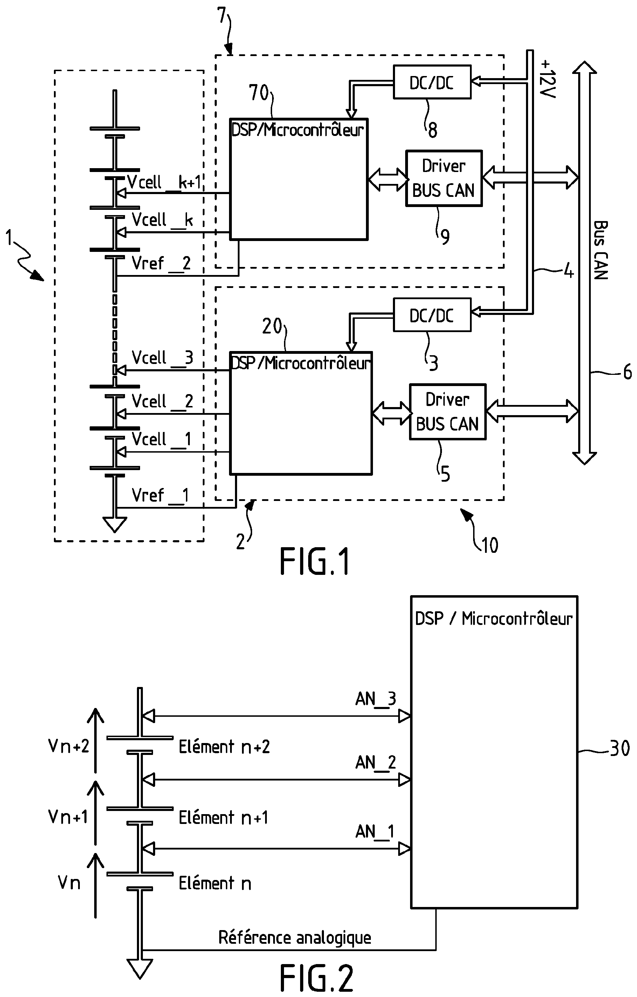

On va tout d'abord décrire, en référence à la figure 1, un dispositif 10 de mesure des tensions aux bornes des différentes cellules d'un système électrochimique 1 tel qu'une batterie, un supercondensateur ou une pile à combustible.

Les différentes tensions Vcell 1,.., k+1 sont mesurées puis traitées par des composants programmables de type DSP (pour « Digital Signal Processor ») ou microcontrôleur 20, 70 et les données sont transmises par un bus de communication CAN 6.

Le dispositif de mesure 10 se présente sous forme modulaire. Chaque module 2, 7 isolé électriquement est chargé de mesurer les tensions Vcell_1,Vcell_2,Vcell_3 ; Vcell_k,Vcell_k+1 d'un nombre de cellules en respectant l'ordre défini par la connexion en série de celles-ci. Il est donc possible de connecter autant de modules 2, 7 que nécessaire pour répondre aux besoins de l'utilisateur, la limite étant fixée par le niveau d'isolation en tension des composants électroniques (environ 1000V dans le cas le plus critique).

Chaque module de mesure 2, 7 comporte un circuit électronique basé autour d'un microcontrôleur 20, 70, son potentiel de référence (masse) correspondant au potentiel le plus faible du paquet d'éléments (Vréf_1, Vréf_2). Ces modules 2, 7 sont alimentés par l'intermédiaire d'un convertisseur DC/DC isolé 3, 8 connecté sur l'alimentation générale du dispositif 10. Les différentes données issues des mesures sont transmises par l'intermédiaire d'un bus de communication. Pour cela, des drivers CAN isolés 5, 9 permettent des liaisons entre les microcontrôleurs 20, 70 et le bus CAN 6 du dispositif de mesure 10.

Les module de mesure 2, 7 sont dupliqués autant de fois que nécessaire pour mesurer les différentes tensions aux bornes de tous les éléments du système électrochimique 1 étudié.

En référence à la figure 2, le potentiel de référence des mesures analogiques du microcontrôleur 30 est connecté à la tension la plus faible de l'ensemble des éléments concernés n, n+1, n+2. Les différentes mesures de tension Vn, Vn+1, Vn+2 sont connectées aux entrées analogiques AN_1, AN_2, AN_3 du microcontrôleur 30 en respectant l'ordre établi par les potentiels : du plus faible au plus fort. La tension aux bornes d'un élément est alors déterminée par la différence de deux tensions consécutives mesurées.

En fonction des niveaux de tension mesurés, les entrées analogiques du microcontrôleur 30 peuvent être connectées directement sur les éléments à mesurer. Pour des tensions plus élevées, un circuit d'adaptation permet d'ajuster la tension dans une plage compatible avec celle du microcontrôleur.

En fonction du microcontrôleur ou du circuit DSP utilisé, le nombre de voies analogiques est variable et limite ainsi le nombre de tensions mesurées sur un sous-ensemble de cellules. Les mesures analogiques peuvent être effectuées de manière simultanée (mesures synchrones) ou séquentielle (mesures asynchrones).

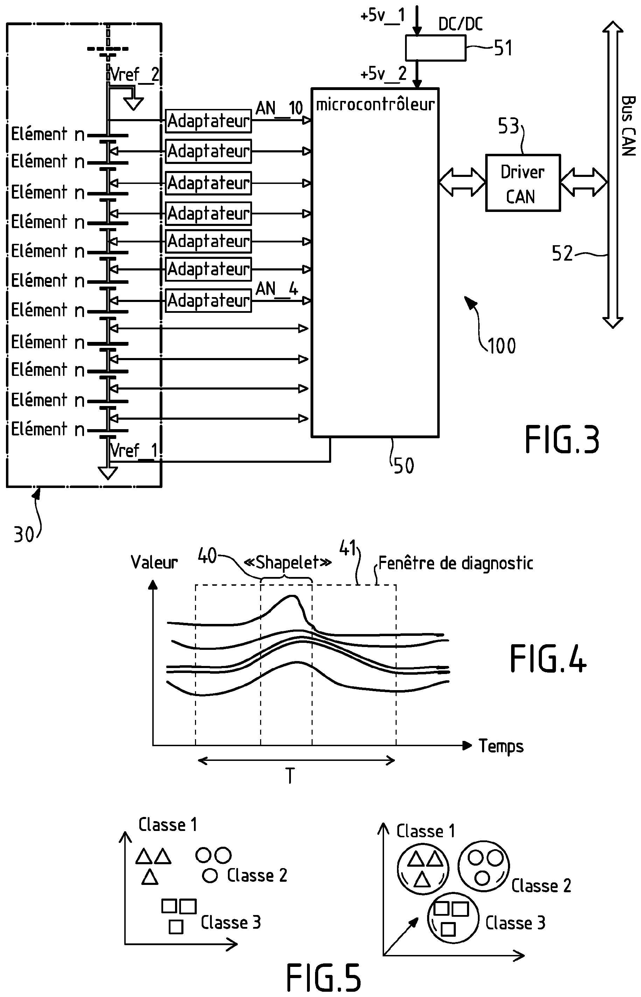

Dans l'exemple de réalisation illustré par la figure 3, le dispositif de mesure 100 est utilisé pour la mesure des tensions des cellules d'une pile à combustible 30. En pratique, la tension des cellules peut atteindre environ 1.43V lors de leur activation, mais la plage de mesure utile est comprise entre 0 et 1V.

Le dispositif de mesure 100 comprend un microcontrôleur 50 comportant 11 entrées analogiques et un seul convertisseur analogique/numérique intégré. On utilise alors le principe de mesures séquentielles pour les différentes voies analogiques. La durée globale de conversion pour les 11 voies reste inférieure à 2ms (150µs par voie, soit 1,6 ms).

Les différentes tensions des cellules de la pile à combustible 40 sont connectées sur les entrées analogiques, de manière directe pour les quatre premières voies (tensions inférieures à 4V) et par l'intermédiaire d'un circuit d'adaptation pour les voies AN_4 à AN_10.

L'alimentation du dispositif de mesure 100 est réalisée à partir d'une source de tension de 5V continue (+5v_1). Un convertisseur DC/DC 51 permet d'obtenir une tension de 5V (+5V_2) isolée pour l'alimentation de l'ensemble de l'électronique. Le circuit utilisé assure une tension d'isolement de 1000V. L'ensemble du dispositif de mesure 100 se trouve ainsi isolé avec un potentiel de référence Vref_1.

Pour assurer cet isolement, les communications entre le microcontrôleur 50 et le reste du système sont effectuées par un bus CAN 52 également isolé. Un circuit driver CAN 53 isole le microcontrôleur 50 en assurant une tension d'isolement de 2500V.

On va maintenant décrire, en référence aux figures 4 à 6, des étapes de traitement qui sont implémentées dans le procédé de diagnostic selon l'invention.

Le procédé de diagnostic selon l'invention est construit autour d'un apprentissage basé sur des données mesurées et connues. Il est ici mis en œuvre dans le but de détecter des défauts d'un système de pile à combustible (PAC) de type PEMFC (pour « Polymer Electrolyte Membrane Fuel Cell »). Il est entendu que le procédé de diagnostic selon l'invention peut être mis en œuvre sans limitation dans d'autres types de piles à combustible.

Ce procédé de diagnostic met en œuvre un dispositif de mesure de tension individuelle des cellules unitaires de la PAC tel que décrit précédemment. Afin de tenir compte de la dynamique du système et de l'hétérogénéité spatiale des différentes cellules qui le composent, le procédé de diagnostic selon l'invention fait appel à un outil d'analyse de série temporelle, appelé dans la suite « Shapelet transform », qui réalise une caractérisation de formes d'onde spécifiques extraites des mesures de tension aux bornes des cellules du système électrochimique.

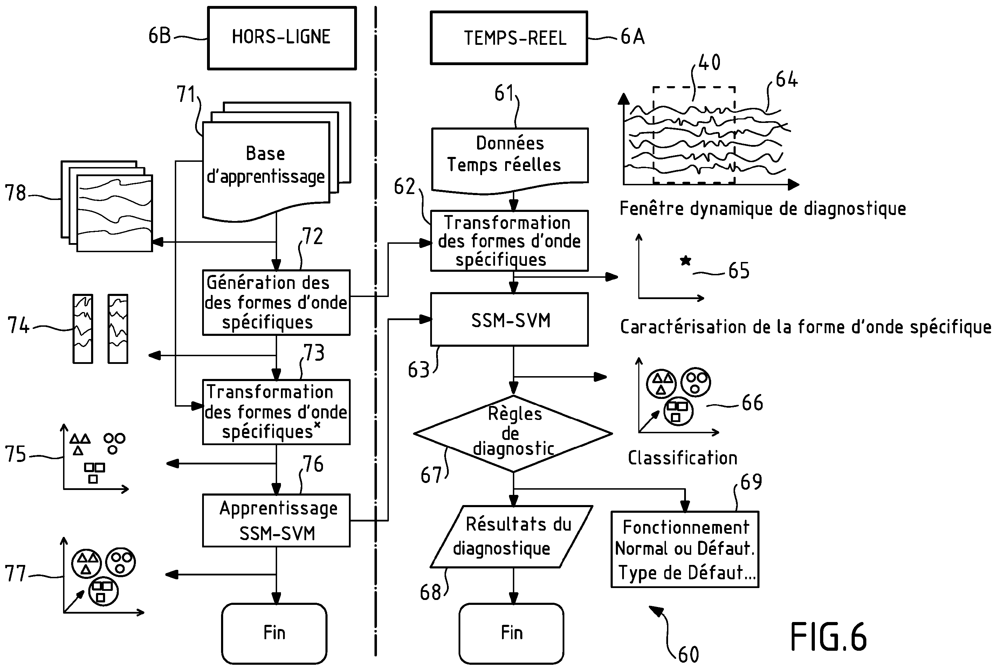

En référence à la figure 6, dans une forme particulière de réalisation du procédé de diagnostic selon l'invention, celui-ci comprend un processus 6A de traitement en temps réel de mesures de tension effectuées sur les cellules de la pile, et un processus 6B de traitement hors ligne de mesures de tension effectuées sur les mêmes cellules mais dans des états de fonctionnement connus incluant des états de dysfonctionnement.

L'outil d'analyse temporelle est utilisé pour extraire des formes d'onde spécifiques ou « shapelets » 40 (Figure 4) issues des données d'une base de données 61 (Figure 6) servant au diagnostic en temps-réel. L'outil d'analyse temporelle est utilisé dans une fenêtre 41 dont la durée est connue et définie préalablement en fonction des défauts considérés. Dans un second temps, un outil de classification SSM-SVM est appliqué dans l'espace dimensionnel considéré (fonction du nombre de défauts).

Les tensions des cellules du système de pile à combustible sont par nature non homogènes de par leurs états physiques au sein d'une pile (ou « stack »), tels que la température, la distribution des gaz, le taux d'humidité relative, la distribution du catalyseur sur la couche d'activation, et on doit considérer la corrélation temporelle entre les échantillons mesurés. Les tensions de cellules échantillonnées dans un intervalle de temps (fenêtre 41) sont considérées comme des variables pour le procédé de diagnostic selon l'invention.

Cette fenêtre d'acquisition est définie mathématiquement comme suit : $T = \left[T\left(1\right),…,T\left({l}_{w}\right)\right] = \left[{v}_{1},…,{v}_{lw}\right]$ (1) où vᵢ est le vecteur échantillonné à l'index i et composé de l'ensemble des tensions d'un nombre n_{cell} decellules.

Ce vecteur vi = [vi (1), vi (2), ... , vᵢ (n_{cell})]. I_{w} est la largeur de la fenêtre d'acquisition.

Chaque observation T est une série chronologique dynamique qui peut être représentée mathématiquement sous la forme d'une matrice, dont la dimension esr définie d'une part par le nombre de cellules et d'autre part par la durée de l'observation I_{w} et dont le nombre de points est défini par la période d'échantillonnage (ou fréquence d'acquisition) du dispositif de mesure.

Dans le processus hors-ligne 6B, une base de données d'apprentissage 71 est constituée à partir de N mesures hors-ligne obtenues au moyen du dispositif de mesure décrit précédemment. Elle est répertoriée par classes notées Ω0, Ω1, Ω2,..., ΩC qui correspondent aux différents défauts. La classe d'indice 0 est définie comme l'état de fonctionnement normal (sans défauts).

L'espace des classes sur l'ensemble des observations Tᵢ est connu au préalable, soit gᵢ ∈ {0,1, ... , C}. Les nombres d'observations 78 qui constituent la base de donnée 71 dans l'ensemble de ces classes sont respectivement N₀, N₁, ...,N_{C} et satisfont l'équation N₀ + N₁ + ··· + N_{C} = N.

On va maintenant plus particulièrement décrire la génération de formes d'onde spécifiques (« Shapelets ») dans les deux processus temps-réel 6A et hors-ligne 6B.

Pour identifier une forme d'onde spécifique, il est nécessaire de produire une quantité de signaux éligibles que l'on appelle candidats et qui sont généré dans le vecteur SCⱼᵢ.

En faisant l'hypothèse que la forme d'onde spécifique est d'une durée Iₛ, les candidats sont sélectionnés en tenant compte de la durée d'observation I_{w}. Par exemple, on considère des candidats jusqu'à I_{w} - Iₛ + 1 pour une observation Tᵢ suivant la formule ci-après : ${SC}_{ji} = \left\{{T}_{i}\left(j\right),{T}_{i}\left(j+1\right),…,{T}_{i}\left(j+{l}_{s}-1\right)\right\} , j = 1 , … , {l}_{w} - {l}_{s} + 1$ (2) où SCⱼᵢ représente le jiéme candidat de la matrice Tᵢ. Comme SCⱼᵢ est issu de Tᵢ, l'espace dans lequel il se situe est également gᵢ. Le nombre de candidats générés à partir de la base d'apprentissage 71 est donc (I_{w} - Iₛ + 1)N.

Dans ce procédé, les durées Is et Iw sont définies préalablement pour chaque classe. Cette définition est faite de manière empirique lors de la constitution de la base de données d'apprentissage.

Pour pouvoir classifier et caractériser les candidats, trois opérations sont nécessaires. La première consiste à calculer la distance entre un candidat SCij et l'observation Tk, qui est égale à la valeur minimum entre le candidat SCij et l'ensemble de candidats générés par cette observation Tk comme suit : $dis \left({SC}_{i , j}, {T}_{k}\right) = {min}_{l ∈ \left(1,…{l}_{w}-{l}_{s}+1,\right)} \left‖{SC}_{i , j}-{SC}_{k , l}\right‖$ (3)

Pour chaque candidat cette distance est calculée, puis la distance moyenne de cette même classe est également définie. $\overline{dιs} \left({SC}_{i , j}\right) = \frac{{\sum }_{gk = gi} dis \left({SC}_{i , j}, {T}_{k}\right)}{{N}_{i}}$ (4)

Grâce aux deux valeurs précédentes, on calcule le facteur de qualité de chaque candidat d'une même classe suivante la formule de discrimination quadratique suivante : $Qual \left({SC}_{i , j}\right) = \frac{{\sum }_{gk \neq gi} dis {\left({SC}_{i , j}, {T}_{k}\right)}^{2}}{{\sum }_{gk = gi} {\left(dis\left({SC}_{i , j}, {T}_{k}\right)-\overline{dis}\left({SC}_{i , j}\right)\right)}^{2}}$ (5)

Lorsque tous les candidats de chaque classe ont été évalués, ils sont classés par ordre décroissant suivant leurs facteurs de qualité. Dans le cas où deux formes d'onde spécifiques candidats de même la base d'observation obtiennent des indices redondants, c'est alors celui qui présente le facteur de qualité le plus élevé qui est conservé. Dans les candidats restants, ce sont ceux qui ont le meilleur facteur de qualité qui sont sélectionnés.

La procédure d'extraction des formes d'onde spécifiques qui vient d'être décrite peut aisément être mise en œuvre sous la forme d'un algorithme avec des techniques logicielles connues. On peut ainsi générer des formes d'onde spécifiques 74 dans le processus hors-ligne 6B et des formes d'onde spécifiques 40 dans le processus temps-réel 6A.

On va maintenant plus particulièrement décrire un exemple d'extraction des formes d'onde spécifiques lors d'un diagnostic temps réel. Pour une fenêtre de diagnostic T (Figure 4) prise arbitrairement, les caractéristiques des formes d'onde spécifiques de cette base arbitraire issue de mesures en temps réel 64 (voir figure 6) sont déterminées en exécutant le calcul de distance avec ceux issus de la base d'apprentissage 71 et sélectionnés comme pertinents.

Ce calcul permet également de connaître la dimension du domaine de caractérisation qui servira à l'initialisation de l'outil 63 de classification SSM-SVM en référence à la figure 6.

On va maintenant décrire un exemple de mise en œuvre de cet outil de classification SSM-SVM dans le procédé de diagnostic selon l'invention.

Pour solutionner le problème de classification non linéaire issue des données d'apprentissage (notamment dû au fait que l'on considère plus de deux classes), la méthode utilisée ci-après est connue sous le nom « kernel trick ».

Dans un premier temps, on réalise une projection des vecteurs dans un espace multidimensionnel via la fonction Φ .

Les vecteurs sont définis comme suit : *zₙ*(*n* ∈ *T*)

Par exemple, pour une classe i, la sphère est calculée comme suit : $\left\{\begin{matrix}{\left‖Φ\left({z}_{n}\right)-{a}_{i}\right‖}^{2} \leq {R}_{i}^{2} + {ξ}_{n}^{i} & if {z}_{n} ∈ {Ω}_{i} \\ {\left‖Φ\left({z}_{n}\right)-{a}_{i}\right‖}^{2} \geq {R}_{i}^{2} - {ξ}_{n}^{i} & if {z}_{n} ∉ {Ω}_{i}\end{matrix}\right.$ (6)

Où *Rᵢ* et *aᵢ* sont respectivement le rayon et le centre du cercle de la sphère i.

La fonction Φ utilisée ici est le noyau Gaussien, soit : $k \left({z}_{m}, {z}_{n}\right) = exp \left(-\frac{{\left‖{z}_{m}-{z}_{n}\right‖}^{2}}{2 {σ}^{2}}\right)$ (7)

La classification SSM-SVM revient donc à solutionner le problème d'optimisation suivant : $\begin{matrix}{min}_{{R}_{i} , {a}_{i}} \left({R}_{i}^{2}+D{\sum }_{n ∈ T} {ξ}_{n}^{i}\right) \\ s . t \left\{\begin{matrix}{c}_{n}^{i} \left({\left‖Φ\left({z}_{n}\right)-{a}_{i}\right‖}^{2}-{R}_{i}^{2}\right) - {ξ}_{n}^{i} \leq 0 \\ {ξ}_{n}^{i} \geq 0\end{matrix} for n∈T\right.\end{matrix}$ (8)

Pour un indice i donné, on minimise la somme du carré du rayon Ri et de la somme des variables d'ajustement multipliée par un paramètre D de réglage permettant le bon ajustement lors de la phase d'apprentissage, avec les contraintes suivantes :
- la distance absolue au carré entre la fonction appliquée au vecteur support zn et le centre de la sphère moins le rayon au carré moins la variable d'ajustement doivent être inférieurs ou égales à zéro
- les variables d'ajustements sont supérieures ou égales à zéro.

En considérant ${c}_{n}^{i} = 1$ si *zₙ* ∈ *Ωₗ*; ${c}_{n}^{i} = - 1$ si *zₙ* ∉ Ω*ₗ* La solution de l'équation d'optimisation (8) est donnée par : $L = {\sum }_{i} {R}_{i}^{2} + D {\sum }_{n , i} {ξ}_{n}^{in} - {\sum }_{n , i} {β}_{n}^{i} {ξ}_{n}^{i} + {\sum }_{n , i} {α}_{n}^{i} \left({c}_{n}^{i}\left({\left‖ϕ\left({z}_{n}\right)-{a}_{i}\right‖}^{2}-{R}_{i}^{2}\right)-{ξ}_{i}^{n}\right)$ (9)

Dans l'équation (9), on retrouve les deux multiplicateurs non-négatifs de Lagrange, ${α}_{n}^{i}$ et ${β}_{n}^{i}$. Ils sont associés aux contraintes décrites en (8). Pour résoudre le problème d'optimisation, il faut donc trouver le l'extremum de L. $\frac{\partial L}{\partial {R}_{i}} = 0 \to {\sum }_{n} {α}_{n}^{i} {c}_{n}^{i} = 1$ (10) $\frac{\partial L}{\partial {a}_{i}} = 0 \to {a}_{i} = {\sum }_{n} {α}_{n}^{i} {c}_{n}^{i} ϕ \left({z}_{n}\right)$ (11) $\frac{\partial L}{\partial {ξ}_{n}^{i}} - 0 \to {α}_{n}^{i} + {β}_{n}^{i} - D et 0 \leq {α}_{n}^{i} \leq D$ (12)

Le rayon de la sphère i, R*ᵢ*, peut être calculé d'après les conditions de Karush-Kuhn-Tucker ( « KKT conditions ») décrites ci-après. ${α}_{n}^{i} \left({c}_{n}^{i}\left({\left‖ϕ\left({z}_{n}\right)-{a}_{i}\right‖}^{2}-{R}_{i}^{2}\right)-{ξ}_{n}^{i}\right) = 0$ $\left(D-{α}_{n}^{i}\right) {ξ}_{n}^{i} = 0$ Donc ${R}_{i}^{2} = {\left‖ϕ\left({z}_{n}\right)-{a}_{i}\right‖}^{2} pour tout les {z}_{n} avec {α}_{n}^{i} ϵ \left(0, D\right)$

A partir de ces calculs analytiques, l'algorithme SSM-SVM peut être codé. Dans l'exemple de mise en œuvre décrit ici, on opère sur un nombre de classe supérieur à 2 et dans un espace de dimensions supérieures à 2.

Cet algorithme permet de décomposer le problème quadratique en une somme de problèmes linéaires qui sont traités un à un. Chaque multiplicateur de Lagrange est calculé individuellement et les vecteurs supports décrivant les sphères englobant les classes sont mis à jours à chaque itération.

La méthode SSM-SVM qui vient d'être décrite permet ainsi de classifier des formes d'onde spécifiques, en référence à la figure 5. Par ailleurs, l'association des formes d'onde spécifiques (ou « shapelets ») et de la classification SSM-SVM permet d'avoir des performances en terme de taux d'erreur supérieures à celles habituellement observées avec les procédés actuels de diagnostic.

L'utilisation de la méthode SSM-SVM permet d'obtenir à la fois des résultats de classification 77 des formes d'onde spécifiques 75 issues d'observations hors-ligne dans un mode d'apprentissage, et des résultats de classification 66 des formes d'onde spécifiques 65 issues de mesures de tension effectuées en temps réel.

Les résultats de classification issus du mode d'apprentissage SSM-SVM 76 sont exploités dans le traitement SSM-SVM 63 des points spécifiques issues de la transformation 62 des formes d'onde spécifiques issues des mesures temps-réel.

On va maintenant décrire, en référence à la figure 6, une stratégie de diagnostic en temps réel mise en œuvre dans le procédé de diagnostic selon l'invention. Les tensions aux bornes des cellules du système électrochimique sont mesurées au moyen du dispositif de mesure décrit précédemment en référence aux figures 1 à 3. Ces mesures sont numérisées à une fréquence d'échantillonnage de 1hz pendant un temps Lw puis stockées sous forme d'un tableau de données temps-réel 61 qui sera ensuite utilisé pour les calculs.

Les données en temps réel sont acquises selon une fenêtre glissante d'acquisition. Une fois le tableau stocké, les distances minimum sont alors calculées via la transformation 62 en forme d'onde spécifique.

Lorsque la forme d'onde spécifique est caractérisée et représentée graphiquement par un point spécifique 65, il est ensuite analysé par l'algorithme SSM-SVM 63 qui va lui affecter une classe en fonction de sa position dans les volumes définis par les sphères, comme l'illustre la figure 5. Chaque classe est associée à un état de fonctionnement (Normal ou décrivant un défaut connu).

Des règles de diagnostic 67 sont ensuite appliquées aux résultats de classification 66 de façon à générer des résultats de diagnostic 68 qui vont permettre de poser un diagnostic de fonctionnement 69 (normal ou défaut, type de défaut,..) qui sera communiqué à la gestion du système électrochimique et possiblement à l'utilisateur ou au personnel chargé de la maintenance de ce système. Ces opérations sont répétées en boucle à chaque nouvelle acquisition (fenêtre) et ce à chaque mise en route du système.

Il est à noter que d'autres méthodes mathématiques, faisant notamment appel aux réseaux de neurones ou encore de type kNN (K Nearest Neighbor) ou GMM (Gaussian Mixture Model), pourraient être utilisées pour réaliser des classifications de formes d'onde spécifiques.

## Revendications

1. Procédé pour diagnostiquer en temps réel l'état de fonctionnement d'un système électrochimique (1, 30) comprenant un empilement de cellules, ce procédé comprenant des étapes pour réaliser des mesures de tension aux bornes desdites cellules, **caractérisé en ce qu'**il comprend en outre :
- un traitement des mesures de tension ainsi réalisées en temps réel pour en extraire des formes d'onde spécifiques (40),
- une transformation (62), appelée « Shapelet transform », desdites formes d'onde spécifiques (40) pour en générer des points (65) spécifiques du fonctionnement temps-réel dudit système électrochimique (1, 30), et
- une comparaison desdits points (65) spécifiques du fonctionnement temps-réel et de points (75) spécifiques d'un fonctionnement hors-ligne dudit système électrochimique (1, 30) qui sont issus d'une transformation (73) de formes d'onde spécifiques (74) extraites de mesures de tension (78) effectuées hors ligne alors que ledit système électrochimique (1, 30) est placé dans des états de fonctionnement connus incluant des états de défaut, de façon à produire des informations (69) sur l'état de fonctionnement temps-réel dudit système électrochimique (1, 30).

2. Procédé selon la revendication 1, **caractérisé en ce que** les étapes de mesure de tension de cellule sont effectuées périodiquement.

3. Procédé selon la revendication 2, **caractérisé en ce que** les points spécifiques sont identifiés dans un espace bidimensionnel (2D) puis classés dans un espace tridimensionnel (3D).

4. Procédé selon la revendication 3, **caractérisé en ce que** des points spécifiques sont classés au moyen d'une fonction (63, 76) de type SSM-SVM (pour « Sphere Shaped Multi-Class - Support Vector Machine »).

5. Procédé selon l'une des revendications 3 ou 4, **caractérisé en ce que** des points spécifiques sont classés au moyen d'une fonction de type kNN (pour « K Nearest Neighbor »).

6. Procédé selon l'une des revendications 3 à 5, caractérisé en que des points spécifiques sont classés au moyen d'une fonction de type GMM (pour « Gaussian Mixture Model »).

7. Procédé selon l'une quelconque des revendications précédentes, **caractérisé en ce qu'**il comprend en outre une constitution initiale d'une base de données par apprentissage (71) sur des états de fonctionnement connus du système électrochimique (1, 30), qui sont testés hors ligne.

8. Procédé selon l'une quelconque des revendications précédentes, mis en œuvre pour diagnostiquer l'état de fonctionnement d'une pile à combustible (30), **caractérisé en ce que** les états de fonctionnement connus testés hors ligne comprennent tout ou partie des états suivants : Fonctionnement Normal, Pression basse hydrogène, Stœchiométrie basse du côté Air, Asséchement, Noyage, Pression élevée.

9. Système pour diagnostiquer l'état de fonctionnement en temps réel d'un système électrochimique (1, 30) comprenant un empilement de cellules, mettant en œuvre le procédé de diagnostic selon l'une quelconque des revendications précédentes, comprenant des moyens pour mesurer les tensions aux bornes desdites cellules, **caractérisé en ce qu'**il comprend en outre :
- des moyens pour traiter les tensions ainsi mesurées pour en extraire des formes d'onde spécifiques,
- des moyens pour transformer, selon une transformation appelée « Shapelet transform », lesdites formes d'onde spécifiques pour en générer des points spécifiques du fonctionnement temps-réel dudit système électrochimique, et
- des moyens pour comparer lesdits points spécifiques du fonctionnement temps-réel et des points spécifiques d'un fonctionnement hors-ligne dudit système électrochimique qui sont issus d'une transformation de formes d'onde spécifiques extraites de mesures de tension effectuées hors ligne alors que ledit système électrochimique est placé dans des états de fonctionnement connus incluant des états de défaut, de façon à extraire des informations sur l'état de fonctionnement temps-réel dudit système électrochimique.

10. Système de diagnostic selon la revendication 9, **caractérisé en ce qu'**il comprend en outre des moyens pour transformer les formes d'onde spécifiques extraites des mesures de tension effectuées hors-ligne et/ou en temps réel, de façon à créer des points spécifiques.

11. Système de diagnostic selon la revendication 10, **caractérisé en ce qu'**il comprend en outre des moyens pour identifier les points spécifiques dans un espace bidimensionnel (2D) et des moyens pour classer lesdits points spécifiques ainsi identifiés dans un espace tridimensionnel (3D).

12. Système de diagnostic selon l'une quelconque des revendications 9 à 11, **caractérisé en ce qu'**il comprend en outre une base de données par apprentissage sur des états de fonctionnement connus dudit système électrochimique.

13. Système électrochimique comportant un empilement de cellules, intégrant un système de diagnostic selon l'une quelconque des revendications 9 à 12.

14. Système électrochimique selon la revendication 13, **caractérisé en ce qu'**il comporte une pile à combustible.

## Patentansprüche

1. Verfahren zum Diagnostizieren des Betriebszustands eines einen Stapel von Zellen umfassenden elektrochemischen Systems (1, 30) in Echtzeit, wobei das Verfahren Schritte zum Durchführen von Spannungsmessungen an den Klemmen der Zellen umfasst, **dadurch gekennzeichnet, dass** es ferner umfasst:
- eine Verarbeitung der so durchgeführten Spannungsmessungen in Echtzeit, um daraus spezifische (40) Wellenformen zu extrahieren;
- eine Transformation (62), "Shapelet Transform" genannt, der spezifischen Wellenformen (40), um daraus spezifische Punkte (65) des Echtzeitbetriebs des elektrochemischen Systems (1, 30) zu generieren, und
- einen Vergleich der spezifischen Punkte (65) des Echtzeitbetriebs und von spezifischen Punkten (75) eines Offline-Betriebs des elektrochemischen Systems (1, 30), die aus einer Transformation (73) von spezifischen Wellenformen (74) hervorgegangen sind, die aus Spannungsmessungen (78) extrahiert werden, die offline ausgeführt werden, während das elektrochemische System (1, 30) in bekannte Betriebszustände, einschließlich von Fehlerzuständen, versetzt wird, so dass Informationen (69) über den Echtzeitbetriebszustand des elektrochemischen Systems (1, 30) erzeugt werden.

2. Verfahren nach Anspruch 1, **dadurch gekennzeichnet, dass** die Schritte zur Zellenspannungsmessung periodisch ausgeführt werden.

3. Verfahren nach Anspruch 2, **dadurch gekennzeichnet, dass** die spezifischen Punkte in einem zweidimensionalen Raum (2D) identifiziert und dann in einem dreidimensionalen Raum (3D) klassifiziert werden.

4. Verfahren nach Anspruch 3, **dadurch gekennzeichnet, dass** spezifische Punkte mittels einer Funktion (63, 76) vom Typ SSM-SVM (für "Sphere Shaped Multi-Class - Support Vector Machine") klassifiziert werden.

5. Verfahren nach einem der Ansprüche 3 oder 4, **dadurch gekennzeichnet, dass** spezifische Punkte mittels einer Funktion vom Typ kNN (für "K Nearest Neighbor") klassifiziert werden.

6. Verfahren nach einem der Ansprüche 3 bis 5, **dadurch gekennzeichnet, dass** spezifische Punkte mittels einer Funktion vom Typ GMM (für "Gaussian Mixture Model") klassifiziert werden.

7. Verfahren nach einem der vorhergehenden Ansprüche, **dadurch gekennzeichnet, dass** es ferner ein anfängliches Aufbauen einer Lerndatenbank (71) für bekannte Betriebszustände des elektrochemischen Systems (1, 30) umfasst, die offline getestet werden.

8. Verfahren nach einem der vorhergehenden Ansprüche, das eingesetzt wird, um den Betriebszustand einer Brennstoffzelle (30) zu diagnostizieren, **dadurch gekennzeichnet, dass** die offline getesteten bekannten Betriebszustände alle oder einen Teil der folgenden Zustände umfassen: Normaler Betrieb, niedriger Wasserstoffdruck, niedrige Stöchiometrie auf der Luftseite, Austrocknung, Flutung, hoher Druck.

9. System zum Diagnostizieren des Betriebszustands eines einen Stapel von Zellen umfassenden elektrochemischen Systems (1, 30) in Echtzeit, welches das Diagnoseverfahren nach einem der vorhergehenden Ansprüche einsetzt, umfassend Mittel zum Messen der Spannungen an den Klemmen der Zellen, **dadurch gekennzeichnet, dass** es ferner umfasst:
- Mittel zum Verarbeiten der so gemessenen Spannungen, um daraus bestimmte Wellenformen zu extrahieren,
- Mittel zum Transformieren der spezifischen Wellenformen gemäß einer "Shapelet Transform" genannten Transformation, um daraus spezifische Punkte des Echtzeitbetriebs des elektrochemischen Systems zu generieren, und
- Mittel zum Vergleichen der spezifischen Punkte des Echtzeitbetriebs und der spezifischen Punkte eines Offline-Betriebs des elektrochemischen Systems, die aus einer Transformation von spezifischen Wellenformen hervorgegangen sind, die aus Spannungsmessungen extrahiert werden, die offline ausgeführt werden, während das elektrochemische System in bekannte Betriebszustände, einschließlich von Fehlerzuständen, versetzt wird, so dass Informationen über den Echtzeitbetriebszustand des elektrochemischen Systems extrahiert werden.

10. Diagnosesystem nach Anspruch 9, **dadurch gekennzeichnet, dass** es ferner Mittel zum Transformieren der aus den offline und/oder in Echtzeit ausgeführten Spannungsmessungen extrahierten spezifischen Wellenformen umfasst, so dass spezifische Punkte erzeugt werden.

11. Diagnosesystem nach Anspruch 10, **dadurch gekennzeichnet, dass** es ferner Mittel zum Identifizieren der spezifischen Punkte in einem zweidimensionalen Raum (2D) und Mittel zum Klassifizieren der so identifizierten spezifischen Punkte in einem dreidimensionalen Raum (3D) umfasst.

12. Diagnosesystem nach einem der Ansprüche 9 bis 11, **dadurch gekennzeichnet, dass** es ferner eine Lerndatenbank für bekannte Betriebszustände des elektrochemischen Systems umfasst.

13. Elektrochemisches System, das einen Stapel von Zellen umfasst und ein Diagnosesystem nach einem der Ansprüche 9 bis 12 beinhaltet.

14. Elektrochemisches System nach Anspruch 13, **dadurch gekennzeichnet, dass** es eine Brennstoffzelle umfasst.

## Claims

1. Method for diagnosing, in real time, the operating state of an electrochemical system (1, 30) comprising a stack of cells, this method comprising steps for performing voltage measurements across the terminals of said cells, **characterized in that** it further comprises:
- real-time processing of the voltage measurements thus performed, in order to extract specific waveforms (40) therefrom,
- transforming (62), using a so-called "shapelet transform", said specific waveforms (40) in order to generate specific points (65) of the real-time operation of said electrochemical system (1, 30) therefrom, and
- comparing said specific points (65) of the real-time operation with specific points (75) of an off-line operation of said electrochemical system (1, 30) that originate from a transformation (73) of specific waveforms (74) extracted from voltage measurements (78) performed off-line while said electrochemical system (1, 30) is placed in known operating states including fault states, so as to produce information (69) relating to the real-time operating state of said electrochemical system (1, 30).

2. Method according to Claim 1, **characterized in that** the cell voltage measurement steps are performed periodically.

3. Method according to Claim 2, **characterized in that** the specific points are identified in a two-dimensional (2D) space, then classified in a three-dimensional (3D) space.

4. Method according to Claim 3, **characterized in that** specific points are classified by means of a Sphere Shaped Multi-Class - Support Vector Machine (SSM-SVM) type function (63, 76).

5. Method according to either of Claims 3 and 4, **characterized in that** specific points are classified by means of a K Nearest Neighbour (kNN) type function.

6. Method according to one of Claims 3 to 5, **characterized in that** specific points are classified by means of a Gaussian Mixture Model (GMM) type function.

7. Method according to any one of the preceding claims, **characterized in that** it further comprises initial establishment of a database through learning (71) of the known operating states of the electrochemical system (1, 30) that are tested off-line.

8. Method according to any one of the preceding claims, implemented in order to diagnose the operating state of a fuel cell (30), **characterized in that** the known operating states that are tested off-line comprise all or some of the following states: normal operation, low hydrogen pressure, low stoichiometry on the air side, drying, flooding, high pressure.

9. System for diagnosing, in real-time, the operating state of an electrochemical system (1, 30) comprising a stack of cells, implementing the diagnostic method according to any one of the preceding claims, comprising means for measuring the voltages across the terminals of said cells, **characterized in that** it further comprises:
- means for processing the voltages thus measured in order to extract specific waveforms therefrom,
- means for transforming, according to a so-called "shapelet transform" transformation, said specific waveforms in order to generate specific points of the real-time operation of said electrochemical system therefrom, and
- means for comparing said specific points of the real-time operation with specific points of an off-line operation of said electrochemical system that originate from a transformation of specific waveforms extracted from voltage measurements performed off-line while said electrochemical system is placed in known operating states including fault states, so as to extract information relating to the real-time operating state of said electrochemical system.

10. Diagnostic system according to Claim 9, **characterized in that** it further comprises means for transforming the specific waveforms extracted from the voltage measurements performed off-line and/or in real time, so as to create specific points.

11. Diagnostic system according to Claim 10, **characterized in that** it further comprises means for identifying the specific points in a two-dimensional (2D) space and means for classifying said specific points thus identified in a three-dimensional (3D) space.

12. Diagnostic system according to any one of Claims 9 to 11, **characterized in that** it further comprises a database through learning of known operating states of said electrochemical system.

13. Electrochemical system comprising a stack of cells, incorporating a diagnostic system according to any one of Claims 9 to 12.

14. Electrochemical system according to Claim 13, **characterized in that** it comprises a fuel cell.
